# EUROPEAN PATENT APPLICATION

(11) **EP 4 531 525 A1**
(43) Date of publication of application: **02.04.2025**
(21) Application number: 24198026.7
(22) Date of filing: 02.09.2024
(51) Int. Cl.: H10K 59/122

(54) **DISPLAY DEVICE AND METHOD OF FABRICATING THE SAME**

(30) Priority: 26.09.2023 KR 20230129838
(71) Applicant: Samsung Display Co., Ltd., Gyeonggi-do 17113 (KR)
(72) Inventor: SHIN, Hyun Eok, Yongin-si (KR); KIM, Keun Woo, Yongin-si (KR); SO, Byung Soo, Yongin-si (KR); SONG, Seung Yong, Yongin-si (KR); LEE, Ju Hyun, Yongin-si (KR); IM, Sung Soon, Yongin-si (KR); JANG, Keun Ho, Yongin-si (KR); JUNG, In Young, Yongin-si (KR)
(74) Representative: Marks & Clerk LLP

(57) **Abstract**

A display device includes a substrate having a light emitting area and a non-light emitting area; a first anode electrode on the light emitting area of the substrate; a pixel defining layer on the non-light emitting area of the substrate and defining a first opening; an organic separator layer on the pixel defining layer and defining a second opening; a first light emitting layer on the first anode electrode; a common electron layer on the first light emitting layer and the organic separator layer; and a common electrode on the common electron layer, wherein the organic separator layer does not overlap the light emitting area, and overlaps the non-light emitting area to be in contact with the pixel defining layer, the first light emitting layer, and the common electron layer.

## Description

### BACKGROUND

### 1. Field

Aspects of the present disclosure relates to a display device and a method of fabricating the same.

### 2. Description of the Related Art

As an information society develops, the demand for a display device for displaying an image is increasing in various forms. For example, the display device has been applied to various electronic devices such as smartphones, digital cameras, laptop computers, navigation devices, and smart televisions. The display devices may be flat panel display devices such as liquid crystal display devices, field emission display devices, or organic light emitting display devices. Among the flat panel display devices, the light emitting display device may include a light emitting element in which each of the pixels of a display panel may emit light by itself, thereby displaying an image without a backlight unit providing the light to the display panel.

As various electronic devices have recently developed, the demand for high-resolution display devices is increasing. Because high-resolution display devices require high pixel integration, the spacing between light emitting elements overlapping each light emitting area may be narrowed. Accordingly, the high-resolution display device may be formed by a pattern process that forms individual pixels rather than a mask process.

### SUMMARY

Aspects of the present disclosure are directed to a display device in which leakage current defects occurring in a light emitting element layer and disconnection defects in a common electrode are eliminated or substantially reduced when forming a plurality of pixels using a photo lithography method, and a method of fabricating the same.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

Details of other embodiments are included in the detailed description and drawings.

According to some embodiments of the present disclosure, there is provided a display device including: a substrate having a light emitting area and a non-light emitting area; a first anode electrode on the light emitting area of the substrate; a pixel defining layer on the non-light emitting area of the substrate and defining a first opening; an organic separator layer on the pixel defining layer and defining a second opening; a first light emitting layer on the first anode electrode; a common electron layer (e.g. common electron injection layer) on the first light emitting layer and the organic separator layer; and a common electrode on the common electron layer, wherein the organic separator layer does not overlap the light emitting area, and overlaps the non-light emitting area to be in contact with the pixel defining layer, the first light emitting layer, and the common electron layer.

In some embodiments, the first light emitting layer may be completely surrounded by the first anode electrode, the pixel defining layer, the organic separator layer, and the common electron layer.

In some embodiments, the first opening may be inside the second opening in a plan view.

In some embodiments, the common electron layer may extend to overlap the light emitting area and the non-light emitting area, wherein the common electron layer may be in contact with the first light emitting layer and the organic separator layer, and wherein the common electron layer may completely cover the first light emitting layer and the organic separator layer.

In some embodiments, the common electron layer may be in contact with the common electrode to overlap the non-light emitting area.

In some embodiments, the display device may further include: a second anode electrode spaced from the first anode electrode with the pixel defining layer positioned therebetween; and a second light emitting layer on the second anode electrode, wherein the first light emitting layer and the second light emitting layer are spaced from each other by the pixel defining layer and the organic separator layer.

In some embodiments, the common electron layer may cover the second light emitting layer, and the first light emitting layer, the organic separator layer, and the second light emitting layer may be connected by the common electron layer.

In some embodiments, the organic separator layer may include: a first surface in contact with the pixel defining layer; a first side surface in contact with the first light emitting layer; a second side surface in contact with the second light emitting layer; and a second surface in contact with the common electron layer.

In some embodiments, the organic separator layer may be completely surrounded by the pixel defining layer, the first light emitting layer, the second light emitting layer, and the common electron layer.

In some embodiments, a gap between the first light emitting layer and the second light emitting layer in a direction parallel to the substrate may be completely filled by the organic separator layer.

In some embodiments, the organic separator layer may include a single material or a mixture including any one of silicon-based, epoxy-based, and acrylic-based organic materials.

According to some embodiments of the present disclosure, there is provided a display device including: a substrate including a plurality of light emitting areas and a plurality of non-light emitting areas; an anode electrode on the light emitting area of the substrate; a pixel defining layer on the non-light emitting area of the substrate and defining a first opening; an organic separator layer on the pixel defining layer and defining a second opening; a light emitting layer on the anode electrode; a common electron layer on the light emitting layer and the organic separator layer; and a common electrode on the common electron layer, wherein the second opening completely surrounds the first opening in a plan view, wherein the organic separator layer does not overlap the light emitting area in a plan view, and wherein the organic separator layer is in a mesh shape while surrounding the plurality of light emitting areas in a plan view.

In some embodiments, the organic separator layer may overlap the pixel defining layer in a direction perpendicular to the substrate in a plan view.

In some embodiments, the organic separator layer may completely surround the anode electrode and the light emitting layer in a plan view.

In some embodiments, the common electron layer may completely cover the light emitting layer and the organic separator layer in a plan view.

In some embodiments, the common electrode may completely cover the light emitting layer and the organic separator layer in a plan view.

According to some embodiments of the present disclosure, there is provided a method of fabricating a display device, the method including: forming a substrate having a light emitting area and a non-light emitting area, a first anode electrode and a second anode electrode spaced from each other on the light emitting area of the substrate, and a pixel defining layer overlapping the non-light emitting area of the substrate and between the first anode electrode and the second anode electrode; forming a first light emitting layer by: forming a first light emitting material layer completely covering the first anode electrode, the second anode electrode, and the pixel defining layer; forming a sacrificial layer on the first light emitting material layer; and removing a remaining portion of the first light emitting material layer and the sacrificial layer except for a portion overlapping the first anode electrode through an etching process; forming a second light emitting layer by: forming a second light emitting material layer completely covering the first light emitting layer, the second anode electrode, and the pixel defining layer; forming a sacrificial layer on the second light emitting material layer; and removing the second light emitting material layer and the sacrificial layer except for a portion overlapping the second anode electrode through an etching process; forming an organic separator layer by: forming an organic separator material layer on the first light emitting layer, the second light emitting layer, and the pixel defining layer; etching a portion of the organic separator material layer; and exposing the sacrificial layer overlapping each of the first and second light emitting layers; removing the sacrificial layer using a wet etching process; forming a common electron injection layer completely covering the first light emitting layer, the second light emitting layer, and the organic separator layer; forming a common electrode on the common electron injection layer, wherein the organic separator layer does not overlap the light emitting area, and wherein the organic separator layer fills and planarizes a gap between the first light emitting layer and the second light emitting layer in a direction parallel to the substrate.

In some embodiments, the sacrificial layer may include a metal material, and the sacrificial layer may include aluminium or silver.

In some embodiments, the removing of the sacrificial layer includes applying an acidic etching solution to the sacrificial layer.

In some embodiments, the first light emitting layer and the second light emitting layer may be formed by a photo lithography process.

At least some of the above and other features of the invention are set out in the claims.

The display device according to some embodiments reduces or prevents disconnection defects in a common electrode and leakage current defects occurring in a light emitting element layer by forming a plurality of pixels using a photo lithography method and disposing a planarized organic layer between the plurality of pixels. In addition, a display device applicable to ultra-high resolution may be provided by forming a plurality of pixels using the photo lithography method.

However, the effects of the embodiments are not restricted to the one set forth herein. The above and other effects of the embodiments will become more apparent to one of daily skill in the art to which the embodiments pertain by referencing the claims.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating an electronic device according to some embodiments of the present disclosure;
FIG. 2 is a perspective view illustrating a display device included in the electronic device, according to some embodiments of the present disclosure;
FIG. 3 is a schematic cross-sectional view of the display device of FIG. 2, according to some embodiments of the present disclosure;
FIG. 4 is a schematic plan view of a display layer of FIG. 3, according to some embodiments of the present disclosure;
FIG. 5 is a plan view illustrating the arrangement of light emitting areas in a display area of FIG. 4, according to some embodiments of the present disclosure;
FIG. 6 is a schematic cross-sectional view of the display area taken along the line X1-X1' of FIG. 5, according to some embodiments of the present disclosure;
FIG. 7 is an enlarged cross-sectional view of a light emitting element of FIG. 6, according to some embodiments of the present disclosure;
FIG. 8 is an enlarged cross-sectional view of a first light emitting area of FIG. 6, according to some embodiments of the present disclosure;
FIG. 9 is an enlarged cross-sectional view of the area 'A' of FIG. 6, according to some embodiments of the present disclosure;
FIG. 10 is a plan view illustrating the arrangement of an organic separator layer in FIG. 5, according to some embodiments of the present disclosure;
FIG. 11 is a plan view illustrating the arrangement of a light emitting element and an organic separator layer in FIG. 5, according to some embodiments of the present disclosure; and
FIGS. 12 to 21 are cross-sectional views illustrating a method of fabricating a portion overlapping the display area, according to some embodiments of the present disclosure.

### DETAILED DESCRIPTION

The present disclosure will now be described more fully herein with reference to the accompanying drawings, in which some embodiments of the disclosure are shown. The disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

It is also to be understood that when a layer is referred to as being "on" another layer or substrate, it may be directly on the other layer or substrate, or one or more intervening layers may also be present. The same reference numbers indicate the same components throughout the specification.

It is to be understood that, although the terms "first," "second," etc. may be used herein to describe various elements, these elements should not be limited by these terms. These terms are used to distinguish one element from another element. For instance, a first element discussed below could be termed a second element without departing from the teachings of the disclosure. Similarly, the second element could also be termed a first element.

Unless otherwise defined, all terms (including technical and scientific terms) used herein have the same meaning as commonly understood by one of ordinary skill in the art to which the inventive concept pertains. It is also to be understood that terms defined in commonly used dictionaries should be interpreted as having meanings consistent with the meanings in the context of the related art, and are expressly defined herein unless they are interpreted in an ideal or overly formal sense.

Hereinafter, embodiments of the present disclosure will be further described in further detail with reference to the accompanying drawings.

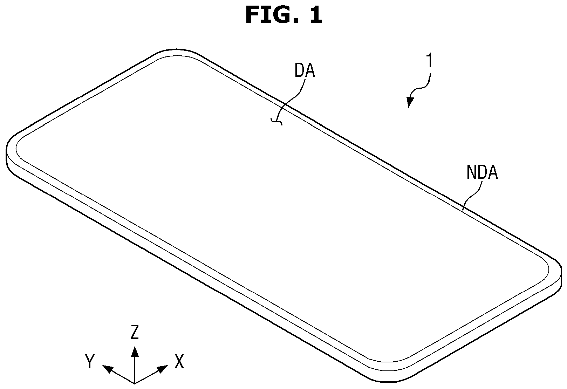

FIG. 1 is a schematic perspective view of an electronic device 1 according to some embodiments of the present disclosure.

Referring to FIG. 1, an electronic device 1 displays a moving image or a still image. The electronic device 1 may refer to any electronic device that provides a display screen. For example, the electronic device 1 may be a television, a laptop computer, a monitor, a billboard, an internet of things device, a mobile phone, a smartphone, a tablet personal computer (PC), an electronic watch, a smartwatch, a watch phone, a head mounted display, a mobile communication terminal, an electronic notebook, an electronic book, a portable multimedia player (PMP), a navigation device, a game console, a digital camera, a camcorder, or the like that provides the display screen.

In FIG. 1, a first direction (X-axis direction), a second direction (Y-axis direction), and a third direction (Z-axis direction) are defined. The first direction (X-axis direction) and the second direction (Y-axis direction) may be perpendicular to each other, the first direction (X-axis direction) and the third direction (Z-axis direction) may be perpendicular to each other, and the second direction (Y-axis direction) and the third direction (Z-axis direction) may be perpendicular to each other. It may be understood that the first direction (X-axis direction) may refer to a horizontal direction in the drawings, the second direction (Y-axis direction) may refer to a vertical direction in the drawings, and the third direction (Z-axis direction) may refer to upper and lower directions in the drawings, that is, a thickness direction. Herein, unless otherwise specified, the term "direction" may refer to both directions toward both sides extending along the direction. In addition, when both "directions" extending to both sides need to be distinguished from each other, one side will be referred to as "one side in the direction" and the other side will be referred to as "the other side in the direction". In FIG. 1, a direction in which an arrow indicating a direction is directed is referred to as one side, and an opposite direction thereof is referred to as the other side.

Hereinafter, for convenience of explanation, in referring to surfaces of the electronic device 1 or each member constituting the electronic device 1, one surface facing one side in a direction in which an image is displayed, that is, in the third direction (Z-axis direction) is referred to as an upper surface, and an opposite surface of the one surface is referred to as the other surface. However, the present disclosure is not limited thereto, and the one surface and the other surface of the member may be referred to as a front surface and a rear surface, respectively, or may also be referred to as a first surface or a second surface. In addition, in describing a relative position of each member of the electronic device 1, one side in the third direction (Z-axis direction) may be referred to as an upper side and the other side in the third direction (Z-axis direction) may be referred to as a lower side.

A shape of the electronic device 1 may be variously changed in a suitable manner. For example, the electronic device 1 may have a shape such as a rectangle, a square, a quadrangle with rounded corners (vertices), other polygons, a circle, the like.

The electronic device 1 may include a display area DA and a non-display area NDA. The display area DA is an area in which a screen may be displayed, and the non-display area NDA is an area in which a screen is not displayed. The display area DA may also be referred to as an active area, and the non-display area NDA may also be referred to as a non-active area. The display area DA may generally occupy the center of the electronic device 1.

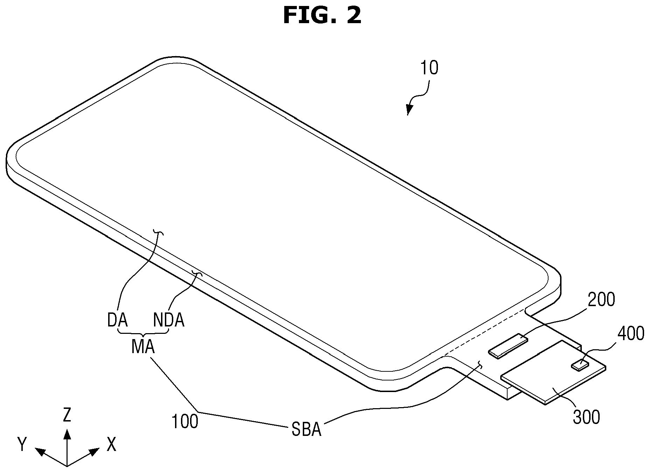

FIG. 2 is a perspective view illustrating a display device 10 included in the electronic device 1 according to some embodiments of the present disclosure.

Referring to FIG. 2, the electronic device 1 according to some embodiments includes a display device 10. The display device 10 may provide a screen displayed by the electronic device 1. Examples of the display device 10 may include an inorganic light emitting diode display device, an organic light emitting display device, a quantum dot light emitting display device, a plasma display device, and a field emission display device. Hereinafter, it is illustrated that an organic light emitting diode display device is used as an example of the display device; however, embodiments of the present disclosure is not limited thereto, and the description herein may also be applied to other suitable display devices.

The display device 10 may have a planar shape similar to that of the electronic device 1. For example, the display device 10 may have a shape similar to a rectangle having a short side in a first direction (X-axis direction) and a long side in a second direction (Y-axis direction). A corner where the short side in the first direction (X-axis direction) and the long side in the second direction (Y-axis direction) meet may be rounded to have a curvature, but is not limited thereto and may also be formed at a right angle. The planar shape of the display device 10 is not limited to the quadrangle, and may be formed similarly to other polygons, circles, or ovals.

The display device 10 may include a display panel 100, a display driver 200, a circuit board 300, and a touch driver 400.

The display panel 100 may include a main area MA and a sub-area SBA. The main area MA may include a display area DA including pixels displaying an image, and a non-display area NDA disposed around the display area DA.

The display area DA may emit light from a plurality of light emitting areas or a plurality of opening areas to be described later. For example, the display panel 100 may include a pixel circuit including switching elements, a pixel defining film defining the light emitting areas or the opening areas, and a self-light emitting element. For example, the self-light emitting element may include, but is not limited to, at least one of an organic light emitting diode (LED) including an organic light emitting layer, a quantum dot LED including a quantum dot light emitting layer, an inorganic LED including an inorganic semiconductor, and a micro LED. In the following drawings, it is illustrated that the self-light emitting element is an organic light emitting diode.

The non-display area NDA may be an area outside the display area DA. The non-display area NDA may be defined as an edge area of the main area MA of the display panel 100. The non-display area NDA may include a wiring driver that supplies signals to the display area DA and wirings connecting the display driver 200 and the display area DA.

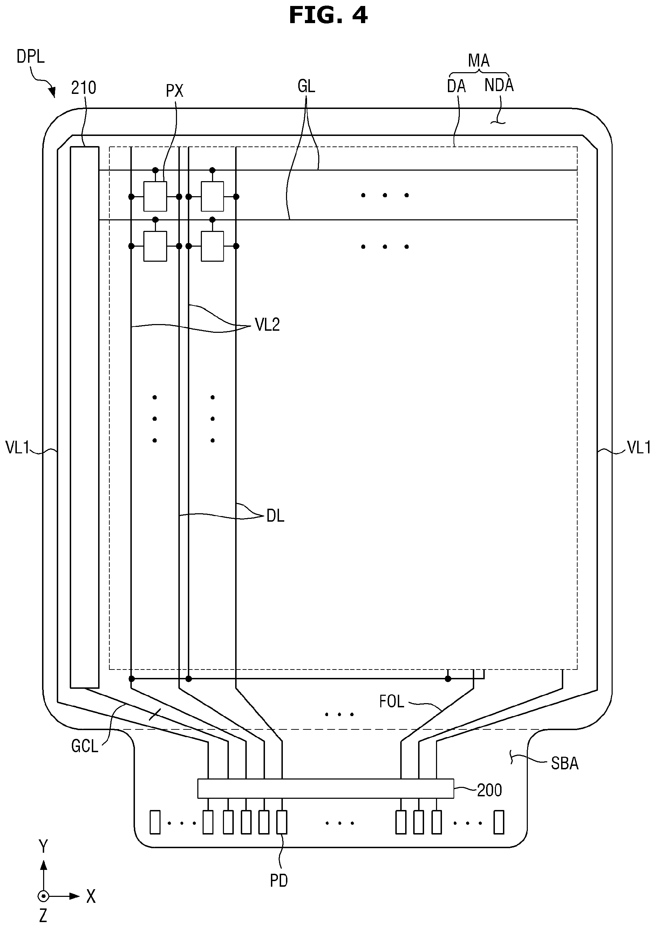

The sub-area SBA may be an area extending from one side of the main area MA. The sub-area SBA may include a flexible material that may be bent, folded, rolled, or the like. For example, when the sub-area SBA is bent, the sub-area SBA may overlap the main area MA in a thickness direction (e.g., a third direction (Z-axis direction)). The sub-area SBA may include a display pad ("PD" in FIG. 4) connected to the display driver 200 and the circuit board 300. In some examples, the sub-area SBA may be omitted, and the display driver 200 and the display pad may be positioned in the non-display area NDA.

The display driver 200 may output signals and voltages for driving the display panel 100. The display driver 200 may supply data voltages to data lines. The display driver 200 may supply a power voltage to a power line and may supply a gate control signal to a gate driver. The display driver 200 may be formed as an integrated circuit (IC) and mounted on the display panel 100 by a chip on glass (COG) method, a chip on plastic (COP) method, an ultrasonic bonding method, and/or the like. For example, the display driver 200 may be disposed in the sub-area SBA, and may overlap the main area MA in the thickness direction by bending of the sub-area SBA. As another example, the display driver 200 may be mounted on the circuit board 300.

The circuit board 300 may be attached onto the pad portion of the display panel 100 using an anisotropic conductive film (ACF). Lead lines of the circuit board 300 may be electrically connected to the pad portion of the display panel 100. The circuit board 300 may be a flexible film such as a flexible printed circuit board, a printed circuit board, or a chip on film.

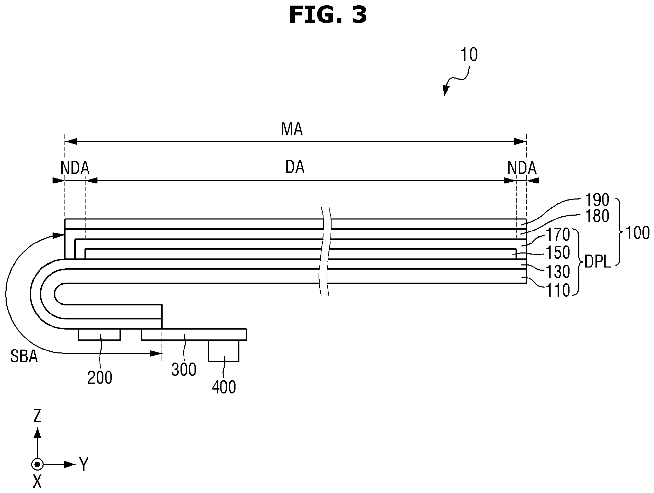

The touch driver 400 may be mounted on the circuit board 300. The touch driver 400 may be connected to a touch sensor layer ("180" in FIG. 3) of the display panel 100. The touch driver 400 may supply a touch driving signal to a plurality of touch electrodes of the touch sensor layer, and may sense an amount of change in capacitance between the plurality of touch electrodes. For example, the touch driving signal may be a pulse signal having a set or predetermined frequency. The touch driver 400 may calculate whether an input is made and input coordinates based on the amount of change in capacitance between the plurality of touch electrodes. The touch driver 400 may be formed as an integrated circuit.

FIG. 3 is a schematic cross-sectional view of the display device 10 of FIG. 2, according to some embodiments of the present disclosure.

Referring to FIG. 3, the display panel 100 may include a display layer DPL, a touch sensor layer 180, and a color filter layer 190. The display layer DPL may include a substrate 110, a thin film transistor layer 130, a display element layer 150, and a thin film encapsulation layer 170.

The substrate 110 may be a base substrate or a base member. The substrate 110 may be a flexible substrate that may be bent, folded, rolled, or the like. For example, the substrate 110 may include a polymer resin such as polyimide PI, but is not limited thereto. In some other embodiments, the substrate 110 includes a glass material, a metal material, and/or the like.

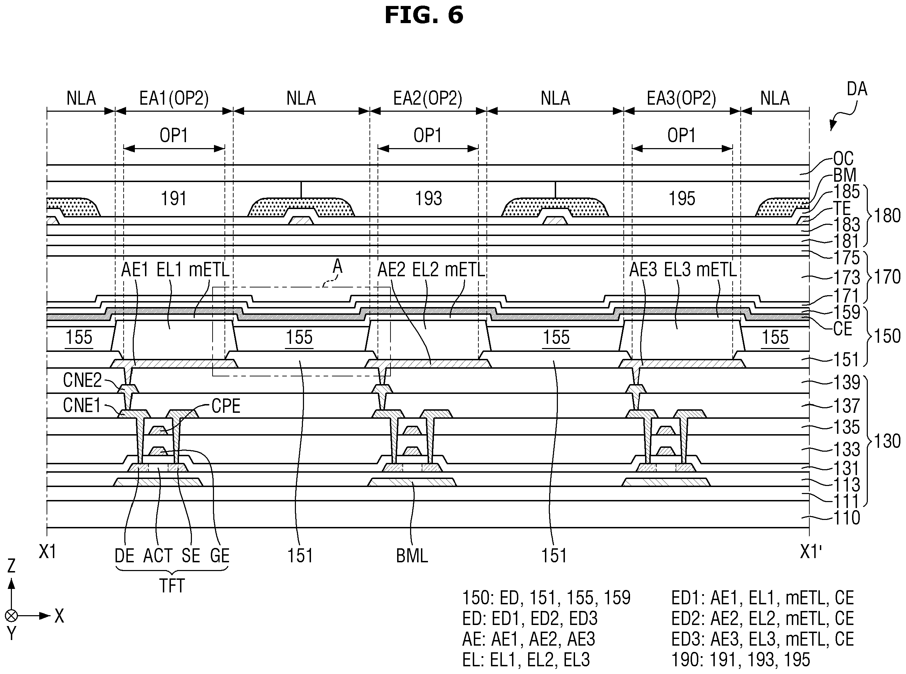

The thin film transistor layer 130 may be disposed on the substrate 110. The thin film transistor layer 130 may be disposed in the display area DA, the non-display area NDA, and the sub-area SBA. The thin film transistor layer 130 may include a plurality of thin film transistors (e.g., "TFT" in FIG. 6) that form part of a pixel (e.g., "PX" in FIG. 4).

The display element layer 150 may be disposed on the thin film transistor layer 130. The display element layer 150 may be positioned to overlap the display area DA. The display element layer 150 may include a plurality of display elements (e.g., "ED1 and ED2" in FIG. 6). As an example, the display element according to some embodiments includes, but is not limited to, at least one of an organic light emitting diode (LED) including an organic light emitting layer, a quantum dot LED including a quantum dot light emitting layer, an inorganic LED including an inorganic semiconductor, and a micro LED.

The thin film encapsulation layer 170 may be positioned on the display element layer 150. The thin film encapsulation layer 170 may be positioned to overlap the display area DA and the non-display area NDA. The thin film encapsulation layer 170 may cover an upper surface and side surfaces of the display element layer 150, and may protect the display element layer 150 from external oxygen and moisture. The thin film encapsulation layer 170 may include at least one inorganic film and at least one organic film for encapsulating the display element layer 150.

The touch sensor layer 180 may be disposed on the thin film encapsulation layer 170. The touch sensor layer 180 may be positioned to overlap the display area DA and the non-display area NDA. The touch sensor layer 180 may sense a user's touch in a mutual capacitance method or a self-capacitance method.

The color filter layer 190 may be disposed on the touch sensor layer 180. The color filter layer 190 may be positioned to overlap the display area DA and the non-display area NDA. The color filter layer 190 may absorb a portion of light introduced from the outside of the display device 10 to reduce reflected light caused by external light. Therefore, the color filter layer 190 may prevent or substantially reduce color distortion caused by reflection of external light.

As the color filter layer 190 is directly disposed on the touch sensor layer 180, the display device 10 may not require a separate substrate for the color filter layer 190. Therefore, the display device 10 may have a relatively small thickness. In some examples, the color filter layer 190 may also be omitted.

As illustrated in FIG. 3, a portion of the display layer DPL overlapping the sub-area SBA may be bent. When a portion of the display layer DPL is bent, the display driver 200, circuit board 300, and touch driver 400 may overlap the main area MA in the third direction (Z-axis direction).

FIG. 4 is a schematic plan view of the display layer DPL of FIG. 3, according to some embodiments of the present disclosure.

Referring to FIG. 4, the display layer DPL according to some embodiments includes a plurality of pixels PX, a plurality of gate lines GL, a plurality of data lines DL, and a plurality of second power lines VL2 overlapping the display area DA of the main area MA.

Each of the plurality of pixels PX may be defined as a minimum unit that emits light. Each of the plurality of pixels PX may form first to third light emitting areas EA1, EA2, and EA3, which will be further described later.

The plurality of gate lines GL may supply a gate signal received from a gate driver 210 to the plurality of pixels PX. The plurality of gate lines GL may extend in the first direction (X-axis direction) and may be spaced apart from each other in the second direction (Y-axis direction) intersecting the first direction (X-axis direction).

The plurality of data lines DL may supply the data voltages received from the display driver 200 to the plurality of pixels PX. The plurality of data lines DL may extend in the second direction (Y-axis direction) and may be spaced apart from each other in the first direction (X-axis direction).

The plurality of second power line VL2 may supply the power voltage received from the display driver 200 to the plurality of pixels PX. Here, the power voltage may be at least one of a driving voltage, an initialization voltage, and a reference voltage. The plurality of second power lines VL2 may extend in the second direction (Y-axis direction) and may be spaced apart from each other in the first direction (X-axis direction).

The display layer DPL according to some embodiments includes a first power line VL1, a gate driver 210, a plurality of fan-out lines FOL, and a gate control line GCL overlapping the non-display area NDA of the main area MA.

The gate driver 210 may generate a plurality of gate signals based on the gate control signal, and may sequentially supply the plurality of gate signals to the plurality of gate lines GL in a particular order (e.g., according to a set order).

The first power line VL1 may surround the display area DA and may be disposed in the non-display area NDA. The first power line VL1 may supply the power voltage received from the display driver 200 to the plurality of pixels PX. In addition, the first power line VL1 may be electrically connected to various wirings positioned in the display area DA.

The plurality of fan-out lines FOL may extend from the display driver 200 to the display area DA. The fan-out lines FOL may supply the data voltage received from the display driver 200 to the plurality of data lines DL.

The gate control line GCL may extend from the display driver 200 to the gate driver 210. The gate control line GCL may supply the gate control signal received from the display driver 200 to the gate driver 210. It is illustrated in the drawing that the gate driver 210 is disposed only in the non-display area NDA disposed on the left side of the display area DA; however, embodiments of the present disclosure are not limited thereto. In some other embodiments, the display device 10 also includes a plurality of gate drivers 210 respectively disposed on the left and right sides of the display area DA.

The display layer DPL according to some embodiments includes a display driver 200 and a plurality of display pads PD overlapping the sub-area SBA.

The display driver 200 may output signals and voltages for driving the plurality of pixels PX to the fan-out lines FOL. The display driver 200 may supply the data voltage to the data lines DL through the plurality of fan-out lines FOL. As a result, the data voltage may be supplied to the plurality of pixels PX and luminance of the plurality of pixels PX may be controlled. In addition, the display driver 200 may supply the gate control signal to the gate driver 210 through the gate control line GCL.

The plurality of display pads PD may be connected to a graphic system through the circuit board 300. The plurality of display pad portions DP may be connected to the circuit board 300 to receive digital video data and supply the digital video data to the display driver 200.

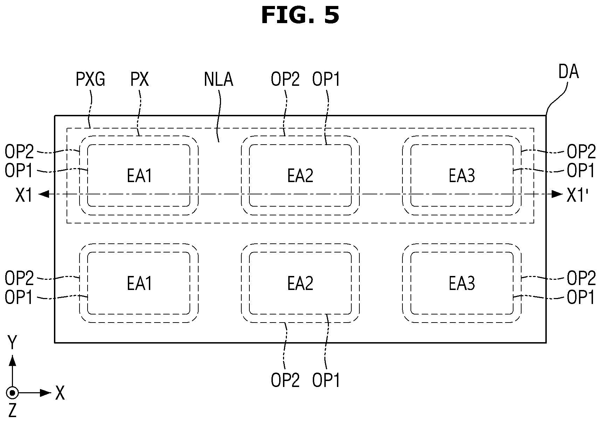

FIG. 5 is a plan view illustrating the arrangement of light emitting areas in the display area DA of FIG. 4, according to some embodiments of the present disclosure.

Referring to FIG. 5, the display area DA may include first to third light emitting areas EA1, EA2, and EA3 and a non-light emitting area NLA.

The non-light emitting area NLA may be positioned to surround each of the first to third light emitting areas EA1, EA2, and EA3. The non-light emitting area NLA may assist in preventing or substantially limiting light emitted from the first to third light emitting areas EA1, EA2, and EA3 from being mixed. An inorganic pixel defining layer (e.g., "151" in FIG. 6) and an organic separator layer 155, which will be further described later, may be disposed in the non-light emitting area NLA.

The first to third light emitting areas EA1, EA2, and EA3 may include a first opening OP1 and a second opening OP2. The first opening OP1 may be defined by the inorganic pixel defining layer 151, and the second opening OP2 may be defined by the organic separator layer 155. For example, the first to third light emitting areas EA1, EA2, and EA3 may be defined by the second opening OP2. In a plan view, the first opening OP1 may be positioned inside the second opening OP2, and in a plan view, the first opening OP1 may be completely surrounded by the second opening OP2.

The plurality of pixels PX may include a first light emitting area EA1, a second light emitting area EA2, and a third light emitting area EA3 that emit light of different colors. Each of the first to third light emitting areas EA1, EA2, and EA3 may each emit red, green, or blue light, and the color of light emitted from each of the first to third light emitting areas EA1, EA2, and EA3 may vary depending on the type of light emitting element ED, which will be further described later. In some embodiments, the first light emitting area EA1 emits red light of a first color, the second light emitting area EA2 emits green light of a second color, and the third light emitting area EA3 emits blue light of a third color; however, embodiments of the present disclosure are not limited thereto.

It is illustrated in FIG. 5 that the size or area of each of the first to third light emitting areas EA1, EA2, and EA3 is the same; however, embodiments of the present disclosure are not limited thereto. As an example, the size and area of the first light emitting area EA1 may be the smallest among the three, and the size and area of the third light emitting area EA3 may be the largest among the three. In other examples, the size and area of the first light emitting area EA1 may be the largest among the three, and the size and area of the third light emitting area EA3 may be the smallest among the three. That is, the size, area, and shape of the first to third light emitting areas EA1, EA2, and EA3 may be freely adjusted as desired.

At least one first light emitting area EA1, at least one second light emitting area EA2, and at least one third light emitting area EA3 disposed to be adjacent to each other may form one pixel group PXG. The pixel group PXG may be a minimum unit that emits white light. However, the type and/or number of light emitting areas EA1, EA2, and EA3 constituting the pixel group PXG may be variously changed according to embodiments.

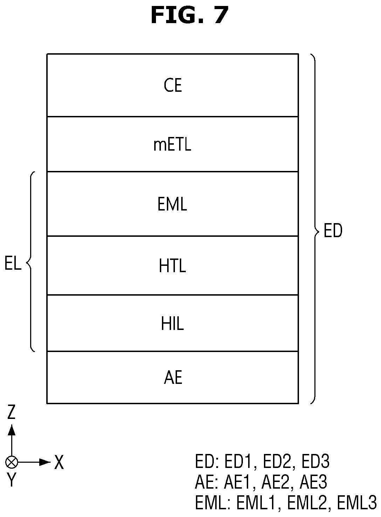

FIG. 6 is a schematic cross-sectional view of the display area DA taken along the line X1-X1' of FIG. 5, according to some embodiments of the present disclosure. FIG. 7 is an enlarged cross-sectional view of a light emitting element ED of FIG. 6, according to some embodiments of the present disclosure.

FIG. 6 is a partial cross-sectional view of the display device 10 overlapping the display area DA, and illustrates a cross section of the substrate 110, the thin film transistor layer 130, the display element layer 150, the thin film encapsulation layer 170, the touch sensor layer 180, and the color filter layer 190. Because the substrate 110 was described with reference to FIG. 3, a description thereof may not be repeated.

Referring to FIG. 6, the thin film transistor layer 130 may be positioned on the substrate 110. The thin film transistor layer 130 may include a first buffer layer 111, a lower metal layer BML, a second buffer layer 113, a thin film transistor TFT, a gate insulating layer 131, a first interlayer insulating layer 133, a capacitor electrode CPE, a second interlayer insulating layer 135, a first connection electrode CNE1, a first via layer 137, a second connection electrode CNE2, and a second via layer 139.

The first buffer layer 111 may be disposed on the substrate 110. The first buffer layer 111 may include an inorganic film capable of preventing or substantially reducing permeation of air or moisture. For example, the first buffer layer 111 may include a plurality of inorganic films alternately stacked.

The lower metal layer BML may be disposed on the first buffer layer 111. For example, the lower metal layer BML may be formed as a single layer or a multilayer made of any one of molybdenum (Mo), aluminium (Al), chromium (Cr), gold (Au), titanium (Ti), nickel (Ni), neodymium (Nd), and copper (Cu), or an alloy thereof.

The second buffer layer 113 may cover the first buffer layer 111 and the lower metal layer BML. The second buffer layer 113 may include an inorganic film capable of preventing or substantially reducing permeation of air or moisture. For example, the second buffer layer 113 may include a plurality of inorganic films alternately stacked.

The thin film transistor TFT may be disposed on the second buffer layer 113, and may form part of a pixel circuit of each of the plurality of pixels. As an example, the thin film transistor TFT may be a driving transistor or a switching transistor of the pixel circuit. The thin film transistor TFT may include an active layer ACT, a source electrode SE, a drain electrode DE, and a gate electrode GE.

The active layer ACT may be disposed on the second buffer layer 113. The active layer ACT may overlap the lower metal layer BML and the gate electrode GE in the thickness direction, and may be insulated from the gate electrode GE by the gate insulating layer 131. In a portion of the active layer ACT, a material of the active layer ACT may become a conductor to form the source electrode SE and the drain electrode DE.

The gate electrode GE may be disposed on the gate insulating layer 131. The gate electrode GE may overlap the active layer ACT with the gate insulating layer 131 interposed therebetween.

The gate insulating layer 131 may be disposed on the active layer ACT. For example, the gate insulating layer 131 may cover the active layer ACT and the second buffer layer 113, and may insulate the active layer ACT and the gate electrode GE from each other. The gate insulating layer 131 may have a contact hole (or contact opening) through which the first connection electrode CNE1 penetrates.

The first interlayer insulating layer 133 may cover the gate electrode GE and the gate insulating layer 131. The first interlayer insulating layer 133 may have a contact hole (or contact opening) through which the first connection electrode CNE1 penetrates. The contact hole of the first interlayer insulating layer 133 may be connected to the contact hole of the gate insulating layer 131 and a contact hole of the second interlayer insulating layer 135.

The capacitor electrode CPE may be disposed on the first interlayer insulating layer 133. The capacitor electrode CPE may overlap the gate electrode GE in the thickness direction. The capacitor electrode CPE and the gate electrode GE may form a capacitance.

The second interlayer insulating layer 135 may cover the capacitor electrode CPE and the first interlayer insulating layer 133. The second interlayer insulating layer 135 may have a contact hole through which the first connection electrode CNE1 penetrates. The contact hole of the second interlayer insulating layer 135 may be connected to the contact hole of the first interlayer insulating layer 133 and the contact hole of the gate insulating layer 131.

The first connection electrode CNE1 may be disposed on the second interlayer insulating layer 135. The first connection electrode CNE1 may electrically connect the drain electrode DE of the thin film transistor TFT and the second connection electrode CNE2 to each other. The first connection electrode CNE1 may be inserted into (e.g., penetrate or fill) the contact holes formed in the second interlayer insulating layer 135, the first interlayer insulating layer 133, and the gate insulating layer 131 and be in contact with the drain electrode DE of the thin film transistor TFT.

The first via layer 137 may cover the first connection electrode CNE1 and the second interlayer insulating layer 135. The first via layer 137 may planarize a lower structure. The first via layer 137 may have a contact hole (or contact opening) through which the second connection electrode CNE2 penetrates.

The second connection electrode CNE2 may be disposed on the first via layer 137. The second connection electrode CNE2 may electrically connect the first connection electrode CNE1 and an anode electrode AE to each other. The second connection electrode CNE2 may be inserted into (e.g., penetrate or fill) the contact hole formed in the first via layer 137 and be in contact with the first connection electrode CNE1.

The second via layer 139 may cover the second connection electrode CNE2 and the first via layer 137. The second via layer 139 may have a contact hole through which the anode electrode AE penetrates.

The display element layer 150 may be disposed on the thin film transistor layer 130. The display element layer 150 may include an inorganic pixel defining layer 151, an organic separator layer 155, a light emitting element ED, and a capping layer 159.

The inorganic pixel defining layer 151 may overlap the non-light emitting area NLA and be disposed on the second via layer 139. The inorganic pixel defining layer 151 may cover a portion of the anode electrode AE in a portion overlapping each of the first to third light emitting areas EA1, EA2, and EA3. In addition, the inorganic pixel defining layer 151 may separate and insulate the first to third anode electrodes AE1, AE2, and AE3 from each other. As described above, the inorganic pixel defining layer 151 may define the first opening OP1.

The inorganic pixel defining layer 151 may include an inorganic insulating material. As an example, the inorganic pixel defining layer 151 may include aluminium oxide, titanium oxide, tantalum oxide, hafnium oxide, zinc oxide, silicon oxide, silicon nitride, silicon oxynitride, and/or the like.

The organic separator layer 155 may be positioned on the inorganic pixel defining layer 151. The organic separator layer 155 may be positioned on a portion overlapping the non-light emitting area NLA. In addition, the organic separator layer 155 may separate and insulate the first to third light emitting layers EL1, EL2, and EL3 from each other. As described above, the organic separator layer 155 may define the second opening OP2, and the first to third light emitting areas EA1, EA2, and EA3 and the non-light emitting area NLA may be defined by the organic separator layer 155. A width of the first opening OP1 in the first direction (X-axis direction) may be less than a width of the second opening OP2. For example, in the cross-sectional view, the first opening OP1 may be positioned inside the second opening OP2.

The organic separator layer 155 includes an organic material. As an example, the organic separator layer 155 may include a silicon-based resin, an acrylic-based resin, an epoxy-based resin, and a mixture thereof.

The light emitting element ED may include a first light emitting element ED1, a second light emitting element ED2, and a third light emitting element ED3 overlapping each of the first to third light emitting areas EA1, EA2, and EA3. The first light emitting element ED1, the second light emitting element ED2, and the third light emitting element ED3 may emit light of different colors depending on the material included in the light emitting layer EL. For example, the first light emitting element ED1 may emit red light of a first color, the second light emitting element ED2 may emit green light of a second color, and the third light emitting element ED3 may emit blue light of a third color.

Referring to FIGS. 6 and 7, the light emitting element ED may include an anode electrode AE, a light emitting layer EL, a common electron transporting layer mETL, and a common electrode CE. In addition, the light emitting layer EL may include a hole injection layer HIL, a hole transporting layer HTL, and an organic light emitting layer EML.

The anode electrode AE may be disposed on the second via layer 139. The anode electrode AE may include a first anode electrode AE1 overlapping the first light emitting area EA1, a second anode electrode AE2 overlapping the second light emitting area EA2, and a third anode electrode AE3 overlapping the third light emitting area EA3. The first anode electrode AE1, the second anode electrode AE2, and the third anode electrode AE3 may be disposed to be spaced apart from each other on the second via layer 139. As described above, the first anode electrode AE1, the second anode electrode AE2, and the third anode electrode AE3 may be spaced apart by the inorganic pixel defining layer 151, and may overlap and be exposed to the first opening OP1. The anode electrode AE may be electrically connected to the drain electrode DE of the thin film transistor TFT through the first and second connection electrodes CNE1 and CNE2.

In some embodiments, the anode electrode AE has a stacked film structure in which a material layer having a high work function, such as indium-tin-oxide (ITO), indium-zinc-oxide (IZO), zinc oxide (ZnO), or indium oxide (In₂O₃) and a reflective material layer such as silver (Ag), magnesium (Mg), aluminium (Al), platinum (Pt), lead (Pd), palladium (Pd), gold (Au), nickel (Ni), neodymium (Nd), iridium (Ir), chromium (Cr), lithium (Li), calcium (Ca), or a mixture thereof are stacked. As an example, the anode electrode AE may have a multilayer structure of ITO/Mg, ITO/MgF, ITO/Ag, and ITO/Ag/ITO, but is not limited thereto.

The light emitting layer EL may be disposed on the anode electrode AE. The light emitting layer EL may be made of an organic material and may be formed on the anode electrode AE through a photo lithography process. The fabricating process will be described in further detail later.

The light emitting layer EL may include a first light emitting layer EL1, a second light emitting layer EL2, and a third light emitting layer EL3 disposed in each of the first to third light emitting areas EA1, EA2, and EA3. The first light emitting layer EL1, the second light emitting layer EL2, and the third light emitting layer EL3 may emit light of different colors depending on the material included in the organic light emitting layer EML, which will be further described later. As an example, the first light emitting layer EL1 may emit red light of a first color, the second light emitting layer EL2 may emit green light of a second color, and the third light emitting layer EL3 may emit blue light of a third color; however, embodiments of the present disclosure are not limited thereto.

The first light emitting layer EL1, the second light emitting layer EL2, and the third light emitting layer EL3 may be disposed to be spaced apart from each other in portions that overlap the first to third light emitting areas EA1, EA2, and EA3 by the inorganic pixel defining layer 151 and the organic separator layer 155.

The light emitting layer EL may include a hole injection layer HIL, a hole transporting layer HTL, and an organic light emitting layer EML. The hole injection layer HIL may be positioned on the anode electrode AE, the hole transporting layer HTL may be positioned on the hole injection layer HIL, and the organic light emitting layer EML may be positioned on the hole transporting layer HTL. In some examples, the hole injection layer HIL and the hole transporting layer HTL may be formed as one layer to form a hole injection and transporting layer.

The hole injection layer HIL may be a single layer made of a single material, a single layer made of a plurality of different materials, or a multilayer structure having a plurality of layers each made of different materials. As an example, the hole injection layer HIL may include, but is not limited to, a phthalocyanine compound such as copper phthalocyanine, DNTPD (N,N'-diphenyl-N,N'-bis-[4-(phenyl-m-tolyl-amino)-phenyl]-biphenyl-4,4'-diamine), m-MTDATA (4,4',4"-tris[(3-methylphenyl)phenylamino]triphenylamine), TDATA (4,4'4"-Tris(N,N-diphenylamino)triphenylamine), 2TNATA (4,4',4"-tris{N,-(2-naphthyl)-N-phenylamino}-triphenylamine), PEDOT/PSS (Poly(3,4-ethylenedioxythiophene)/Poly(4-styrenesulfonate)), PANI/DBSA (Polyaniline/Dodecylbenzenesulfonic acid), PANI/CSA (Polyaniline/Camphor sulfonic acid), PANI/PSS ((Polyaniline)/Poly(4-styrenesulfonate)), and/or the like.

The hole transporting layer HTL may be a single layer made of a single material, a single layer made of a plurality of different materials, or a multilayer structure having a plurality of layers each made of different materials. As an example, the hole transporting layer HTL may include, but is not limited to, carbazole-based derivatives such as N-phenylcarbazole and polyvinylcarbazole, fluorene-based derivatives, triphenylamine-based derivatives such as TPD (N,N'-bis(3-methylphenyl)-N,N'-diphenyl-[1,1-biphenyl]-4,4'-diamine), TCTA (4,4',4"-tris(N-carbazolyl)triphenylamine), NPB (N,N'-di(1-naphthyl)-N,N'-diphenylbenzidine), TAPC (4,4'-Cyclohexylidene bis[N,N-bis(4-methylphenyl)benzenamine]), and/or the like.

The organic light emitting layer EML may include a first organic light emitting layer EML1, a second organic light emitting layer EML2, and a third organic light emitting layer EML3 overlapping each of the first to third light emitting areas EA1, EA2, and EA3. The organic light emitting layer EML may include a host material and a dopant material. The first organic light emitting layer EML1, the second organic light emitting layer EML2, and the third organic light emitting layer EML3 may emit light of different colors by using a phosphorescent or fluorescent material as a dopant in the host material and combining the host material and the dopant material.

The host material is not particularly limited and may include, for example, Alq3 (tris(8-hydroxyquinolino)aluminium), CBP (4,4'-bis(N-carbazolyl)-1,1'-biphenyl), PVK (poly(n-vinylcabazole)), ADN (9,10-di(naphthalene-2-yl)anthracene), TCTA (4',4"4"-Tris(carbazolezol-9-yl)-triphenylamine), TPBi (1,3,5-tris(N-phenylbenzimidazole-2-yl)benzene), TBADN (3-tert-butyl-9,10-di(naphth-2-yl)anthracene), DSA (distyrylarylene), CDBP (4,4'-bis(9-carbazolyl)-2,2'-dimethylbiphenyl), MADN (2-Methyl-9,10-bis(naphthalen-2-yl)anthracene), and/or the like.

As an example, when the first organic light emitting layer EML1 emits red light, the first organic light emitting layer EML1 may include a fluorescent material including perylene or PBD:Eu(DBM)₃(Phen) (tris(dibenzoylmethanato)phenanthoroline europium). In this case, the included dopant material may be selected from, for example, a metal complex or an organometallic complex such as PIQIr(acac) (bis(1-phenylisoquinoline)acetylacetonate iridium), PQIr(acac) (bis(1-phenylquinoline)acetylacetonateiridium), PQIr (tris(1-phenylquinoline)iridium), and PtOEP (octaethylporphyrin platinum).

As an example, when the second organic light emitting layer EML2 emits green light, the second organic light emitting layer EML2 may include a fluorescent material including tris(8-hydroxyquinolino)aluminium (Alq3). In this case, the included dopant material may be selected from, for example, a metal complex or an organometallic complex such as Ir(ppy)s (fac-tris(2-phenylpyridine)iridium).

As an example, when the third organic light emitting layer EML3 emits blue light, the third organic light emitting layer EML3 may include a fluorescent material including any one selected from the group consisting of spiro-DPVBi, spiro-6P, distyryl-benzene (DSB), distyryl-arylene (DSA), polyfluorene (PFO)-based polymers, and poly(p-phenylene vinylene) (PPV)-based polymers. In this case, the included dopant material may be selected from, for example, a metal complex or an organometallic complex such as (4,6-F₂ppy)₂Irpic. However, the materials included in the organic light emitting layer EML are only examples and are not limited thereto.

The common electron transporting layer mETL may be disposed on the light emitting layer EL. The common electron transporting layer mETL may be a common layer disposed to overlap the first to third light emitting areas EA1, EA2, and EA3 and the non-light emitting area NLA. For example, the common electron transport layers mETL disposed to overlap each of the first to third light emitting areas EA1, EA2, and EA3 may extend from each other.

The common electron transporting layer mETL may serve to inject and transport electrons transferred from the common electrode CE to the light emitting layer EL. As an example, the common electron transporting mETL may include an electron transport material such as Alq3 (Tris(8-hydroxyquinolinato)aluminium), TPBi (1,3,5-Tris(1-phenyl-1H-benzo[d]imidazolezol-2-yl)benzene), BCP (2,9-Dimethyl-4,7-diphenyl-1,10-phenanthroline), Bphen (4,7-Diphenyl-1,10-phenanthroline), TAZ (3-(4-Biphenylyl)-4-phenyl-5-tert-butylphenyl-1,2,4-triazole), NTAZ (4-(Naphthalen-1-yl)-3,5-diphenyl-4H-1,2,4-triazole), tBu-PBD (2-(4-Biphenylyl)-5-(4-tert-butylphenyl)-1,3,4-oxadiazole), BAIq (Bis(2-methyl-8-quinolinolato-N1,O8)-(1,1'-Biphenyl-4-olato)aluminium), Bebq2 (berylliumbis(benzoquinolin-10-olate), ADN (9,10-di(naphthalene-2-yl)anthracene), and a mixture thereof, and lanthanide metals such as LiF, LiQ (Lithium quinolate), Li₂O, BaO, NaCl, CsF, Yb, or halogenated metals such as RbCl and Rbl, but is not limited thereto.

The common electrode CE may be disposed on the common electron transporting layer mETL. The common electrode CE according to some embodiments is a common layer disposed to overlap the first to third light emitting areas EA1, EA2, and EA3 and the non-light emitting area NLA.

The common electrode CE may include a transparent conductive material so that light generated in the light emitting layer EL may be emitted. The common electrode CE may receive a common voltage or a low potential voltage. When the anode electrode AE receives the voltage corresponding to the data voltage and the common electrode CE receives the low potential voltage, holes and electrons may each move to the organic light emitting layer EML through the hole transporting layer HTL, the hole injection layer HIL, and the common electron transporting layer mETL, and the moved holes and electrons may combine with each other in the organic light emitting layer EML to emit light. That is, as a potential difference is formed between the anode electrode AE and the common electrode CE, the light emitting layer EL may emit light.

In some embodiments, the common electrode CE includes a material layer having a small work function, such as Li, Ca, LiF/Ca, LiF/Al, Al, Mg, Ag, Pt, Pd, Ni, Au, Nd, Ir, Cr, BaF, Ba, or a compound or mixture thereof (e.g., a mixture of Ag and Mg, etc.). The common electrode CE may further include a transparent metal oxide layer disposed on the material layer having the small work function.

The capping layer 159 may be disposed on the common electrode CE. The capping layer 159 may be a common layer disposed to overlap the first to third light emitting areas EA1, EA2, and EA3 and the non-light emitting area NLA. The capping layer 159 may prevent or substantially reduce damage to the plurality of light emitting elements ED by external air. As an example, the capping layer 159 may include aluminium oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), silicon oxynitride (Si₂N₂O), and/or the like.

The thin film encapsulation layer 170 may be positioned on the capping layer 159. The thin film encapsulation layer 170 may be disposed in a portion overlapping the first to third light emitting areas EA1, EA2, and EA3 and the non-light emitting area NLA.

The thin film encapsulation layer 170 includes at least one inorganic film to prevent or substantially limit oxygen or moisture from permeating into the display element layer 150. The thin film encapsulation layer 170 may include at least one organic film to protect the display element layer 150 from foreign substances such as dust. The thin film encapsulation layer 170 may include a first encapsulation layer 171, a second encapsulation layer 173, and a third encapsulation layer 175 that are sequentially stacked. The first encapsulation layer 171 and the third encapsulation layer 175 may be inorganic encapsulation layers, and the second encapsulation layer 173 disposed therebetween may be an organic encapsulation layer.

The first encapsulation layer 171 and the third encapsulation layer 175 may each include one or more inorganic insulating materials. The inorganic insulating material may include aluminium oxide (Al₂O₃), titanium oxide (Ti₂O₃), tantalum oxide (Ta₂O₅), hafnium oxide (HfO₂), zinc oxide (ZnO), silicon oxide (SiO₂), silicon nitride (Si₃N₄), silicon oxynitride (Si₂N₂O), and/or the like.

The second encapsulation layer 173 may include a polymer-based material. The polymer-based material may include a silicone-based resin, an acrylic-based resin, an epoxy-based resin, and a mixture thereof. For example, the second encapsulation layer 173 may include an acrylic-based resin, such as, polymethyl methacrylate, polyacrylic acid, or the like. The second encapsulation layer 173 may be formed by curing a monomer or applying a polymer.

The touch sensor layer 180 may be disposed on the thin film encapsulation layer 170. The touch sensor layer 180 may include a touch buffer layer 181, a touch insulating layer 183, a touch electrode TE, and a touch protection layer 185.

The touch buffer layer 181 may be disposed on the thin film encapsulation layer 170. The touch buffer layer 181 may have insulation and optical functions. The touch buffer layer 181 may include at least one inorganic film. In some examples, the touch buffer layer 181 may be omitted.

A connection electrode that electrically connects the touch electrodes may be disposed on the touch buffer layer 181. The connection electrode may be formed as a single layer made of molybdenum (Mo), titanium (Ti), copper (Cu), aluminium (Al), indium tin oxide (ITO), and/or the like, or be formed as a stacked structure of aluminium and titanium (e.g., Ti/Al/Ti), a stacked structure of aluminium and ITO (e.g., ITO/AI/ITO), an APC alloy, and a stacked structure of an APC alloy and ITO (e.g., ITO/APC/ITO) or the like.

The touch insulating layer 183 may cover the touch buffer layer 181. The touch insulating layer 183 may have insulation and optical functions. For example, the touch insulating layer 183 may be an inorganic film including at least one of a silicon nitride layer, a silicon oxynitride layer, a silicon oxide layer, a titanium oxide layer, an aluminium oxide layer, and/or the like.

Some of the touch electrodes TE may be disposed on the touch insulating layer 183. Each of the touch electrodes TE may not overlap the first to third light emitting areas EA1, EA2, and EA3 and may be positioned in the non-light emitting area NLA. Each of the touch electrodes TE may be formed as a single layer made of molybdenum (Mo), titanium (Ti), copper (Cu), aluminium (Al), indium tin oxide (ITO), and/or the like, or be formed as a stacked structure of aluminium and titanium (e.g., Ti/Al/Ti), a stacked structure of aluminium and ITO (e.g., ITO/AI/ITO), an APC alloy, and a stacked structure of an APC alloy and ITO (e.g., ITO/APC/ITO), or the like.

The touch protection layer 185 may cover the touch electrode TE and the touch insulating layer 183. The touch protection layer 185 may have insulation and optical functions. The touch protection layer 185 may be made of the materials illustrated in the touch insulating layer 183.

The light blocking layer BM may be disposed on the touch sensor layer 180. The light blocking layer BM may be disposed to overlap the non-light emitting area NLA and overlap the inorganic pixel defining layer 151 and the organic separator layer 155.

The light blocking layer BM may include a light absorbing material. For example, the light blocking layer BM may include an inorganic black pigment or an organic black pigment. The inorganic black pigment may be carbon black, and the organic black pigment may include at least one of lactam black, perylene black, and aniline black, but is not limited thereto. The light blocking layer BM may prevent or substantially limit visible light from permeating and mixing colors between the first to third light emitting areas EA1, EA2, and EA3, thereby improving (e.g., increasing) a color reproduction rate of the display device 10.

The color filter layer 190 may overlap the first to third light emitting areas EA1, EA2, and EA3 and be each disposed on the touch protection layer 185 and the light blocking layer BM. The color filter layer 190 may include a first color filter 191, a second color filter 193, and a third color filter 195 disposed to correspond to the first to third light emitting areas EA1, EA2, and EA3, respectively. Each of the color filters 191, 193, and 195 overlapping each of the first to third light emitting areas EA1, EA2, and EA3 may include a colorant such as a dye or pigment that absorbs light in a different wavelength band other than light in a specific wavelength band, and may be disposed to correspond to the color of light emitted from the first to third light emitting areas EA1, EA2, and EA3. For example, the first color filter 191 may be a red color filter that is disposed to overlap the first light emitting area EA1 and transmits only red light of a first color. The second color filter 193 may be a green color filter that is disposed to overlap the second light emitting area EA2 and transmits only green light of a second color, and the third color filter 195 may be a blue color filter that is disposed to overlap the third light emitting area EA3 and transmits only blue light of a third color, but the present disclosure is not limited thereto.

In some examples, the color filter layer 190 may also be omitted.

An overcoat layer OC may be disposed on the color filter layer 190 to planarize an upper end of the color filter layer 190. The overcoat layer OC may be a colorless light-transmitting layer having no color in a visible light band. For example, the overcoat layer OC may include a colorless light-transmitting organic material such as an acryl-based resin.

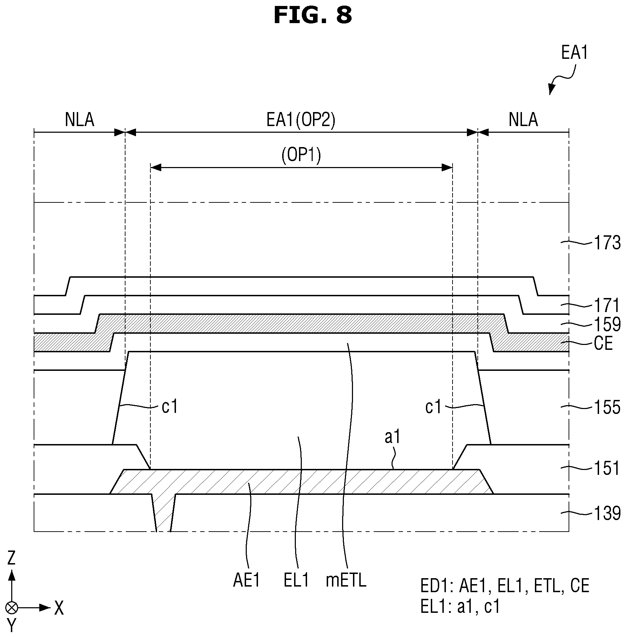

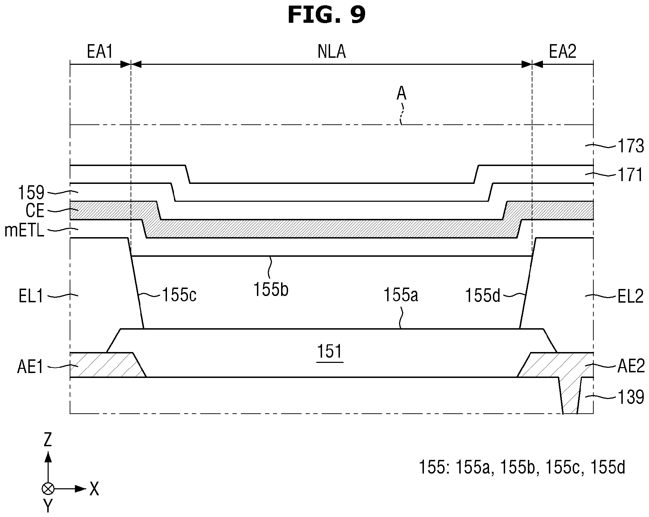

FIG. 8 is an enlarged cross-sectional view of a first light emitting area EA1 of FIG. 6, according to some embodiments of the present disclosure. FIG. 9 is an enlarged cross-sectional view of the area 'A' of FIG. 6, according to some embodiments of the present disclosure.

Referring to FIG. 8, the inorganic pixel defining layer 151 may be positioned on the second via layer 139 and the first anode electrode AE1. The inorganic pixel defining layer 151 may expose the first anode electrode AE1 at a portion overlapping the first opening OP1. A step may be formed between the first anode electrode AE1 and the inorganic pixel defining layer 151. For examples, a height of the inorganic pixel defining layer 151 in the third direction (Z-axis direction) may be formed to be higher than a height of the first anode electrode AE1.

The first light emitting element ED1 may include a first anode electrode AE1, a first light emitting layer EL1, a common electron transporting layer mETL, and a common electrode CE. The first light emitting layer EL1 may be formed on the first anode electrode AE1 and the inorganic pixel defining layer 151 overlapping the first light emitting area EA1.

In the display device 10 according to some embodiments, the light emitting layer EL is formed through a photo lithography process. Because the photo lithography process forms the light emitting layer EL through a photo process and an etching process without a mask, it may be easy to fabricate high-resolution products with narrow spacing between a plurality of pixels PX adjacent to each other. In addition, by being formed through the photo lithography process, the light emitting layer EL may have clear side surfaces without tail defects, thereby eliminating or substantially reducing leakage current defects.

Here, the tail defect may refer to a portion of the material of the light emitting layer EL that overlaps the non-light emitting area NLA in addition to the light emitting area EA due to a gap between the mask and the substrate 110, when the light emitting layer EL is formed through a deposition process using the mask. For example, the tail defect formed in a portion overlapping the non-light emitting area NLA may also be expressed as a mask shadowing defect. The tail defects and mask shadowing defects may cause leakage current.

In some embodiments, the first light emitting layer EL1 may include a lower surface a1 and two side surfaces c1. The lower surface a1 of the first light emitting layer EL1 may be one surface that is in contact with the first anode electrode AE1 and the inorganic pixel defining layer 151. Therefore, the lower surface a1 of the first light emitting layer EL1 may be formed along a profile of a step formed by the first anode electrode AE1 and the inorganic pixel defining layer 151. Both side surfaces c1 of the first light emitting layer EL1 may be surfaces facing corresponding non-light emitting areas NLA, and may be surfaces patterned by an etching process during the process of fabricating the light emitting layer EL1. Therefore, as mentioned above, both side surfaces c1 of the first light emitting layer EL1 may have clear side surfaces without the tail defects and may be in contact with the organic separator layer 155.

In some embodiments, the first light emitting layer EL1 may be in contact with the first anode electrode AE1, the inorganic pixel defining layer 151, the organic separator layer 155, and the common electron transporting layer mETL, and the first light emitting layer EL1 is completely surrounded by the first anode electrode AE1, the inorganic pixel defining layer 151, the organic separator layer 155, and the common electron transporting layer mETL.

The organic separator layer 155 may be disposed on the inorganic pixel defining layer 151.

A high step may be formed between the plurality of light emitting layers EL1, EL2, and EL3 and the inorganic pixel defining layer 151. This high step may cause disconnection defects in the common electron transporting layer mETL and the common electrode (CE) in subsequent processes. Therefore, the display device 10 according to some embodiments includes the organic separator layer 155 overlapping the non-light emitting area NLA, thereby planarizing the step formed by the plurality of light emitting layers EL1, EL2, and EL3 and the inorganic pixel defining layer 151. This may assist in connecting the common electron transporting layer mETL and the common electrode CE formed in the subsequent process without disconnection, thereby eliminating or substantially reducing the disconnection defect of the common electron transporting layer mETL and the common electrode CE.

Referring to FIG. 9, the organic separator layer 155 may include a first surface 155a, a second surface 155b, a first side surface 155c, and a second side surface 155d. The first surface 155a of the organic separator layer 155 may be in contact with the inorganic pixel defining layer 151, and the second surface 155b of the organic separator layer 155 may be in contact with the common electron transporting layer mETL. In addition, the first side surface 155c of the organic separator layer 155 may be in contact with the first light emitting layer EL1, and the second side surface 155d of the organic separator layer 155 may be in contact with the second light emitting layer EL2. For example, the organic separator layer 155 may be in contact with the inorganic pixel defining layer 151, a plurality of adjacent light emitting layers EL, and the common electron transporting layer mETL, and the organic separator layer 155 may be completely surrounded by the inorganic pixel defining layer 151, the plurality of adjacent light emitting layers EL, and the common electron transporting layer mETL. It is illustrated in the drawing that the organic separator layer 155 has an inverted taper shape; however, embodiments of the present disclosure are not limited thereto. The organic separator layer 155 may be formed into various shapes according to the shape of the photo lithography method during the process of fabricating the display device 10.

Referring to FIGS. 6 to 9, the common electron transporting layer mETL and the common electrode CE according to some embodiments are formed on the entire surface of the lower structure to overlap the first to third light emitting areas EA1, EA2, and EA3 and the non-light emitting area NLA. As described above, the display device 10 according to some embodiments includes the organic separator layer 155 overlapping the non-light emitting area NLA, thereby reducing the step formed by the plurality of light emitting layers EL1, EL2, and EL3 and the inorganic pixel defining layer 151. Therefore, it is possible to eliminate or substantially reduce the disconnection defect of the common electron transporting layer mETL and the common electrode CE by overlapping the first to third light emitting areas EA1, EA2, and EA3 and the non-light emitting area NLA.

For convenience of explanation, the first anode electrode AE1 and the first light emitting layer EL1 disposed to overlap the first light emitting area EA1 are illustrated and described, but the first to third anode electrodes AE1, AE2, and AE3 and the first to third light emitting layers EL1, EL2, and EL3 may include the same structure and characteristics. As such, descriptions of common features and characteristics may be omitted.

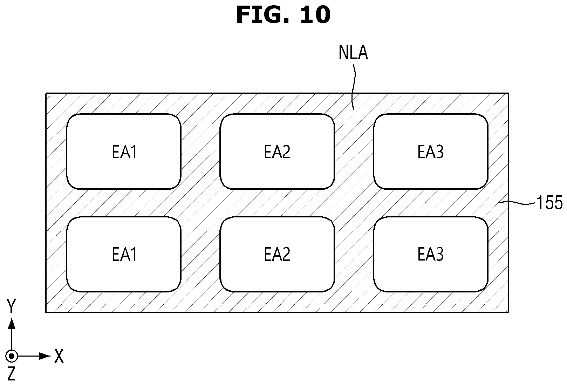

FIG. 10 is a plan view illustrating the arrangement of the organic separator layer 155 in FIG. 5, according to some embodiments of the present disclosure.

Referring to FIG. 10, in a plan view, the organic separator layer 155 may define the first to third light emitting areas EA1, EA2, and EA3 and the non-light emitting area NLA. That is, in a plan view, the organic separator layer 155 may be positioned to surround the first to third light emitting areas EA1, EA2, and EA3, and expose the first to third light emitting areas EA1, EA2, and EA3. For example, in a plan view, the organic separator layer 155 may have a mesh shape that does not overlap the light emitting area EA and instead overlaps the non-light emitting area NLA.

In a plan view, the inorganic pixel defining layer 151 is disposed to overlap the non-light emitting area NLA, and may overlap the organic separator layer 155 in the third direction (Z-axis direction).

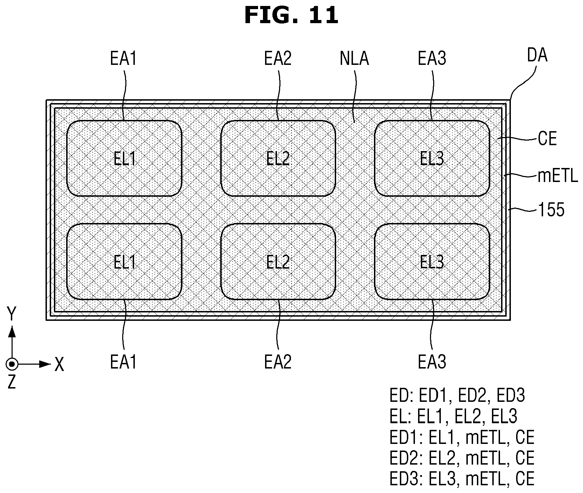

FIG. 11 is a plan view illustrating the arrangement of the light emitting element ED and the organic separator layer 155 in FIG. 5, according to some embodiments of the present disclosure.

Referring to FIG. 11, as described above, the first light emitting element ED1 may include the first light emitting layer EL1, the common electron transporting layer mETL, and the common electrode CE; the second light emitting element ED2 may include the second light emitting layer EL2, the common electron transporting layer mETL, and the common electrode CE; and the third light emitting element ED3 may include the third light emitting layer EL3, the common electron transporting layer mETL, and the common electrode CE.

In a plan view, the organic separator layer 155 may be positioned to surround each of the first to third light emitting layers EL1, EL2, and EL3, which are positioned to overlap each of the first to third light emitting areas EA1, EA2, and EA3. That is, in a plan view, the organic separator layer 155 and the first to third light emitting layers EL1, EL2, and EL3 may not overlap.

In addition, in a plan view, the common electron transporting layer mETL may be disposed on the first to third light emitting layers EL1, EL2, and EL3 and the organic separator layer 155, and in a plan view, the common electron transporting layer mETL may completely cover the first to third light emitting layers EL1, EL2, and EL3 and the organic separator layer 155.

In addition, in a plan view, the common electrode CE may be disposed on the common electron transporting layer mETL and may completely cover the common electron transporting layer mETL. For example, in a plan view, the common electrode CE may completely cover the first to third light emitting layers EL1, EL2, and EL3 and the organic separator layer 155.

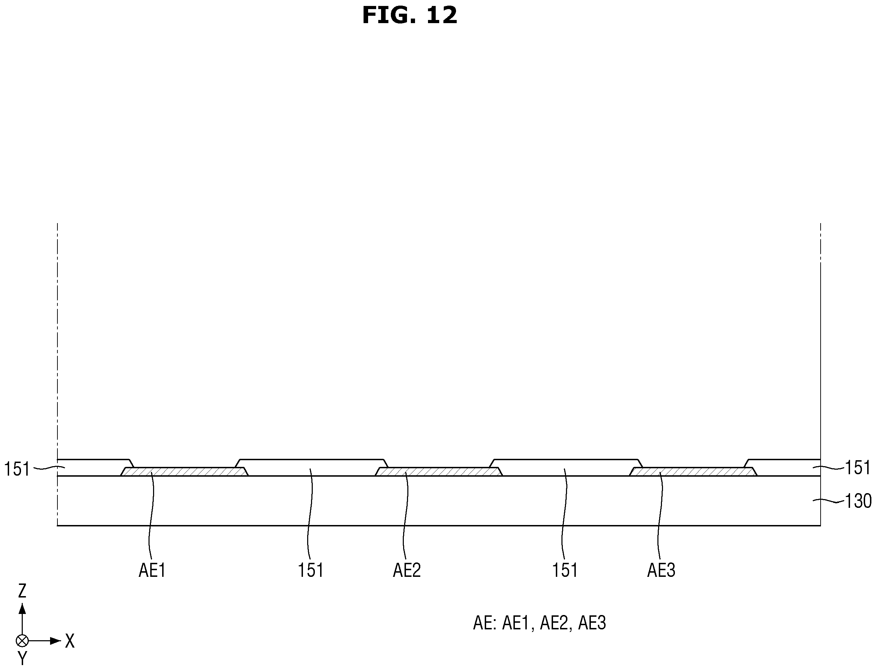

FIGS. 12 to 21 are cross-sectional views illustrating a method of fabricating a portion overlapping the display area DA, according to some embodiments of the present disclosure. For example, FIGS. 12 to 21 schematically illustrate the order of forming the inorganic pixel defining layer 151 overlapping the non-light emitting area NLA, the organic separator layer 155, and the plurality of light emitting elements ED overlapping the first to third light emitting areas EA1, EA2, and EA3. Hereinafter, the process of fabricating the display device 10 will be further described with respect to the order of forming each layer.

Referring to FIG. 12, a plurality of anode electrodes AE and inorganic pixel defining layers 151 are formed on the thin film transistor layer 130. The plurality of anode electrodes AE may include first to third anode electrodes AE1, AE2, and AE3, which may later be disposed to overlap each of the first to third light emitting areas EA1, EA2, and EA3. The thin film transistor layer 130 may be disposed on the substrate 110, and a structure of the thin film transistor layer 130 may be the same as that described above with reference to FIG. 6. As such, a detailed description thereof may not be repeated.

An inorganic pixel defining layer 151 may be disposed between the plurality of anode electrodes AE. The inorganic pixel defining layer 151 may cover a portion of the plurality of anode electrodes AE. The inorganic pixel defining layer 151 may later be disposed to overlap the non-light emitting area NLA.

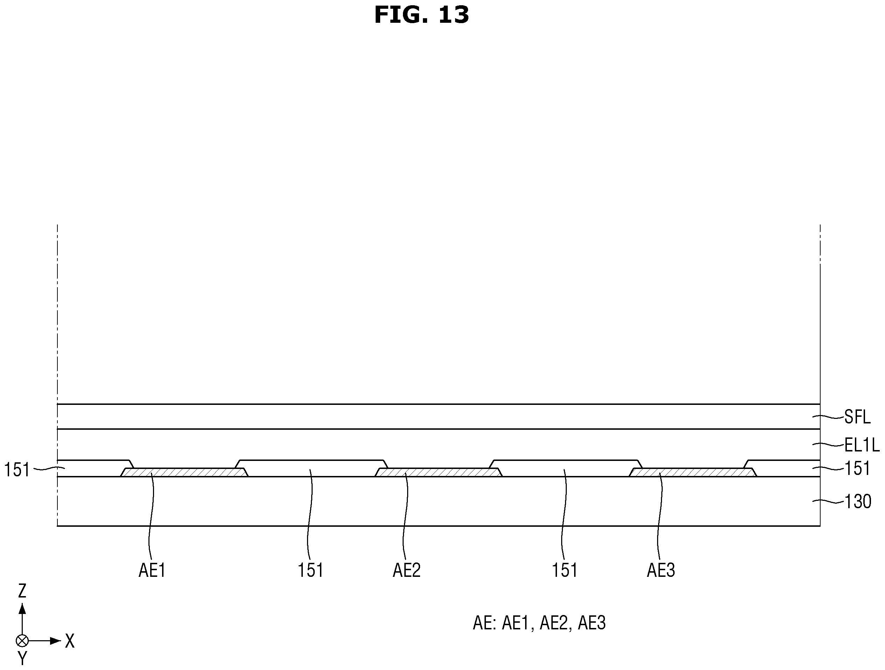

Next, referring to FIG. 13, a first light emitting material layer EL1L may be formed to completely cover the plurality of anode electrodes AE and the inorganic pixel defining layer 151 (e.g., to cover the entirety of the plurality of anode electrodes AE and the inorganic pixel defining layer 151). The first light emitting material layer EL1L may include a hole injection layer HIL, a hole transporting layer HTL, and a first organic light emitting layer EML1. In addition, a sacrificial layer SFL may be disposed on the first light emitting material layer EL1L. The sacrificial layer SFL may protect the first light emitting material layer EL1L from an etching solution when the first light emitting material layer EL1L is subjected to a photo lithography process and an etching process in a subsequent process. The sacrificial layer SFL may be formed directly on the first light emitting material layer EL1L and may include a metal material. As an example, the sacrificial layer SFL may include, but is not limited to, aluminium (Al) and silver (Ag).

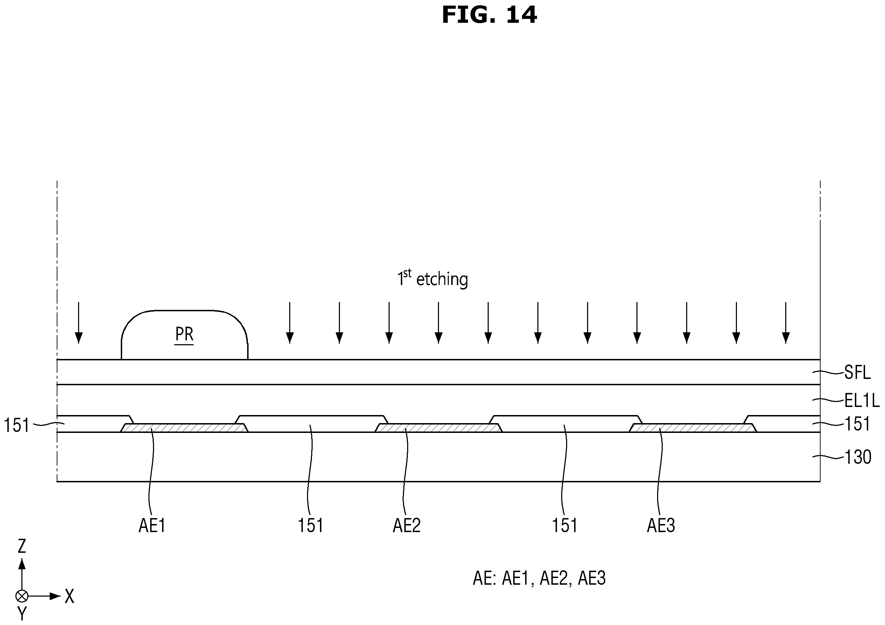

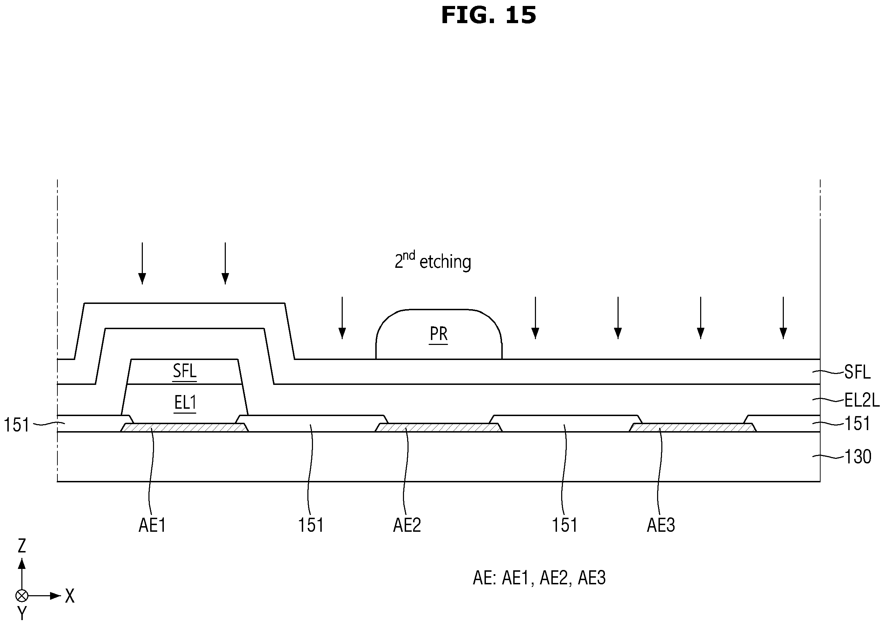

Next, referring to FIG. 14, a first etching process (i.e., 1^{st} etching) of forming a photo resist PR on the sacrificial layer SFL overlapping the first anode electrode AE1 and etching a portion of the sacrificial layer SFL and the first light emitting material layer EL1L using the photo resist PR as a mask is performed. In this process, as illustrated in FIG. 15, the first light emitting layer EL1 and the sacrificial layer SFL disposed to overlap the first anode electrode AE1 may be formed. The first etching process may be performed as a single dry etching process or may be performed alternately as a dry etching process and a wet etching process.

Next, referring to FIG. 15, a second light emitting material layer EL2L and a sacrificial layer SFL are entirely formed on the sacrificial layer SFL positioned on the first light emitting layer EL1, the inorganic pixel defining layer 151, the second anode electrode AE2, and the third anode electrode AE3. In this process, the second light emitting material layer EL2L may cover the first light emitting layer EL1. The second light emitting material layer EL2L may include a hole injection layer HIL, a hole transporting layer HTL, and a second organic light emitting layer EML2.

Next, a second etching process (i.e., 2^{nd} etching) of forming a photo resist PR on the sacrificial layer SFL overlapping the second anode electrode AE2 and etching a portion of the sacrificial layer SFL and the second light emitting material layer EL2L using the photo resist PR as a mask is performed. The second etching process may be the same process as the first etching process.

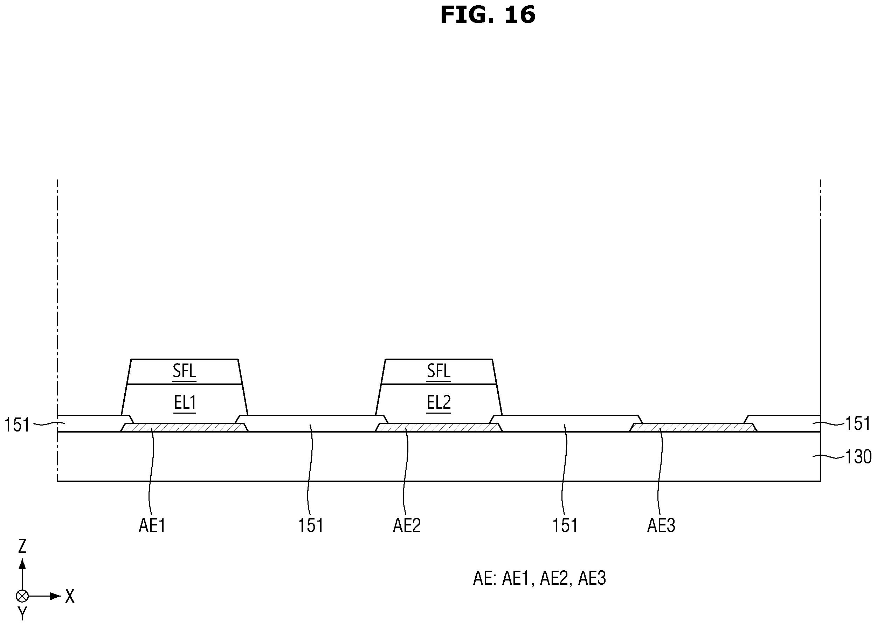

In this process, as illustrated in FIG. 16, the second light emitting layer EL2 and the sacrificial layer SFL disposed to overlap the second anode electrode AE2 may be formed. As described above, the first light emitting layer EL1 and the second light emitting layer EL2 may have a clear cross section without tail defects and mask shadow defects because of being formed through the photo lithography process.

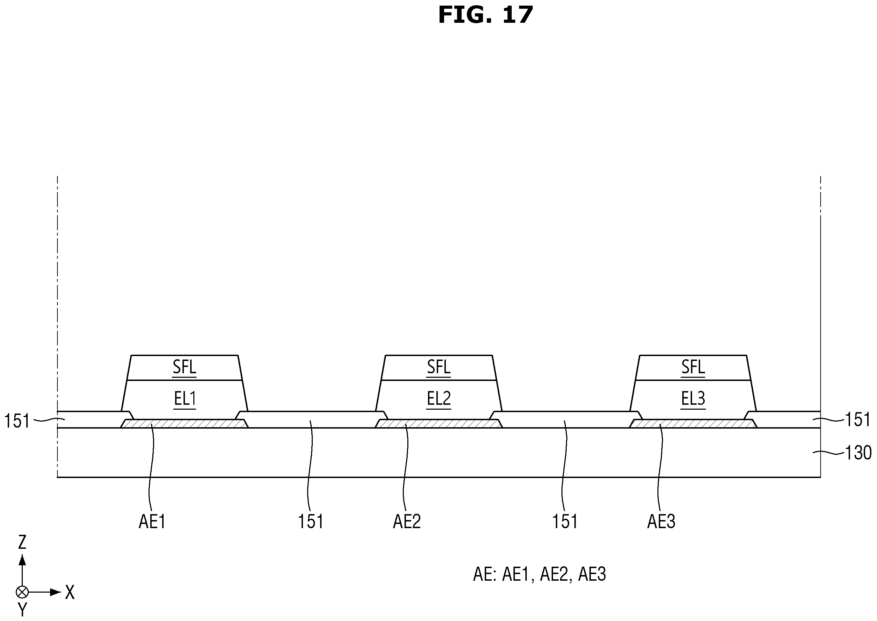

Referring to FIG. 17, a third light emitting layer EL3 and a sacrificial layer SFL overlapping the third anode electrode AE3 are formed by repeating the previously performed process. That is, the third light emitting layer EL3 and the sacrificial layer SFL overlapping the third light emitting layer EL3 may be formed by forming the third light emitting material layer on the sacrificial layer SFL overlapping the first light emitting layer EL1, the sacrificial layer SFL overlapping the second light emitting layer EL2, the inorganic pixel defining layer 151, and the third anode electrode AE3 and forming the photo resist PR on the sacrificial layer SFL overlapping the third anode electrode AE3. In this process, the third light emitting layer EL3 and the sacrificial layer SFL disposed to overlap the third anode electrode AE3 may be formed.

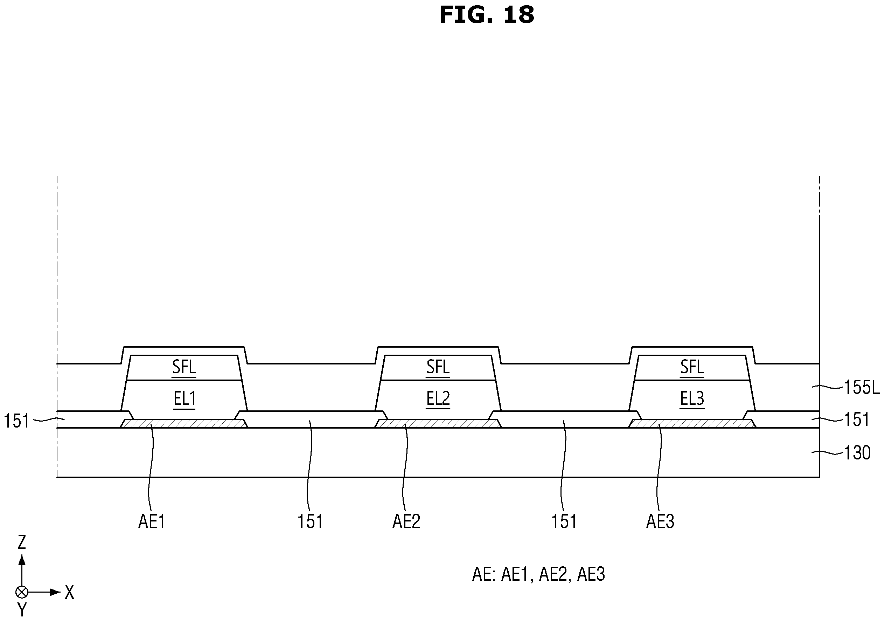

Next, referring to FIG. 18, an organic separator material layer 155L is applied onto the sacrificial layer SFL overlapping the first light emitting layer EL1, the sacrificial layer SFL overlapping the second light emitting layer EL2, the sacrificial layer SFL overlapping the third light emitting layer EL3, and the plurality of inorganic pixel defining layers 151. The organic separator material layer 155L including a fluid organic material may cover upper surfaces of the plurality of light emitting layers EL1, EL2, and EL3, and may also fill and planarize the steps formed between the plurality of light emitting layers EL1, EL2, and EL3 and the inorganic pixel defining layer 151. The organic separator material layer 155L may be cured by UV after application.

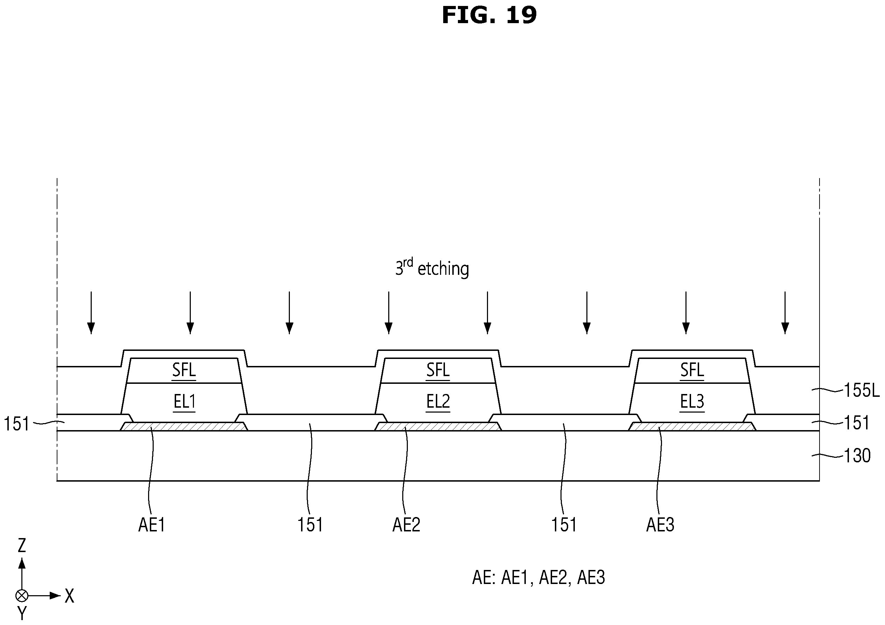

Next, referring to FIG. 19, a third etching process (i.e., 3^{rd} etching) of etching the organic separator material layer 155L overlapping the plurality of anode electrodes AE is performed. The third etching process may include a dry etching process. Through this process, each sacrificial layer SFL overlapping the plurality of anode electrodes AE may be exposed, and the organic separator material layer 155L may be formed in the shape of the organic separator layer 155 illustrated in FIG. 6.

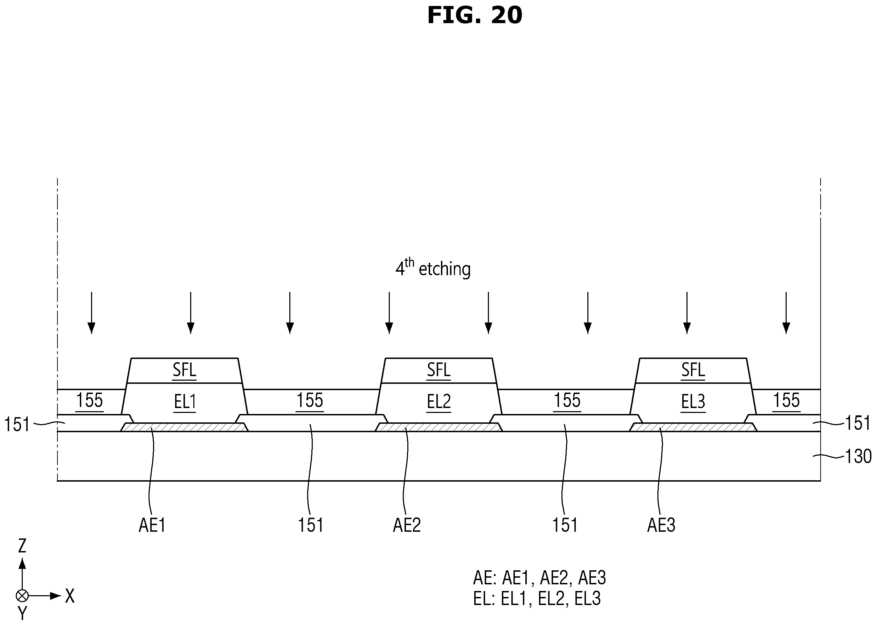

Next, as illustrated in FIG. 20, a fourth etching process (i.e., 4^{th} etching) of removing the sacrificial layer SFL disposed to overlap each anode electrode AE is performed. The fourth etching process may be performed as a wet etching process, and an acidic etching solution may be used as an etching solution. The reason for limiting this process to the acidic etching solution may be to minimize or substantially reduce damage to the plurality of light emitting layers EL. In this process, the sacrificial layer SFL may be removed, and the first light emitting layer EL1, the second light emitting layer EL2, and the third light emitting layer EL3 may be formed as illustrated in FIG. 6. In addition, through this process, the first to third light emitting areas EA1, EA2, and EA3 and the non-light emitting area NLA illustrated in FIG. 6 may be defined.

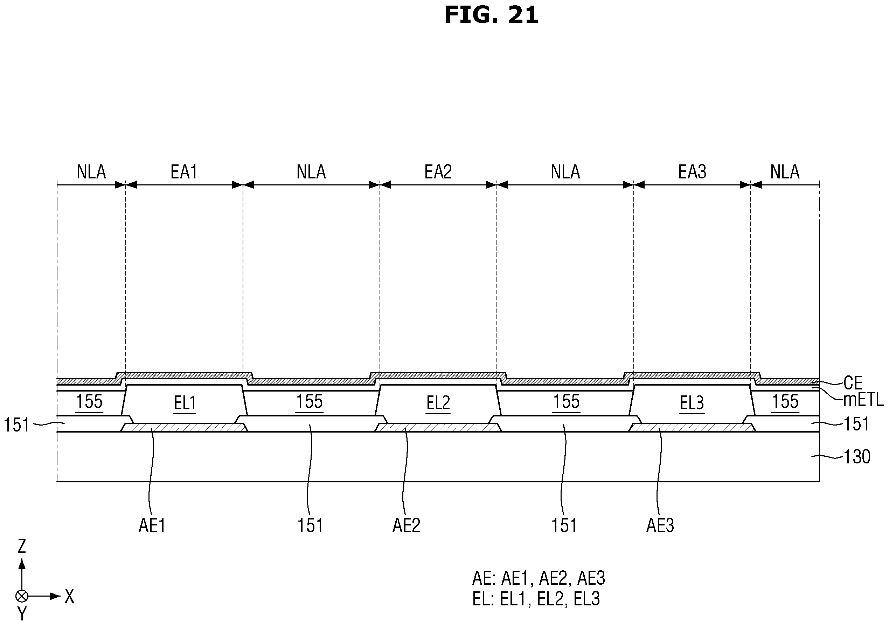

Finally, referring to FIG. 21, a common electron transporting layer mETL covering the first light emitting layer EL1, the second light emitting layer EL2, the third light emitting layer EL3, and the organic separator layer 155 is formed. In addition, a common electrode CE is entirely formed on the common electron transporting layer mETL. As described above, because the display device 10 according to some embodiments includes the organic separator layer 155 on the inorganic pixel defining layer 151, the common electron transporting layer mETL and the common electrode CE may be stably connected without being disconnected. Therefore, the display device 10 according to some embodiments has electrical stability.

The display device 10 may be fabricated by forming a capping layer 159, a first encapsulation layer 171, a second encapsulation layer 173, and a third encapsulation layer 175 on the common electrode CE to form a thin film encapsulation layer 170, and forming a touch sensor layer 180, a light blocking layer BM, a color filter layer 190, and an overcoat layer OC. In some examples, the color filter layer 190 may be omitted. As a result, as illustrated in FIG. 6, a structure overlapping the display area DA may be formed.

It should be understood that embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims and equivalents thereof.

## Claims

1. A display device comprising:
a substrate having a light emitting area and a non-light emitting area;
a first anode electrode on the light emitting area of the substrate;
a pixel defining layer on the non-light emitting area of the substrate and defining a first opening;
an organic separator layer on the pixel defining layer and defining a second opening;
a first light emitting layer on the first anode electrode;
a common electron layer on the first light emitting layer and the organic separator layer; and
a common electrode on the common electron layer,
wherein the organic separator layer does not overlap the light emitting area, and overlaps the non-light emitting area to be in contact with the pixel defining layer, the first light emitting layer, and the common electron layer.

2. The display device of claim 1, wherein the first light emitting layer is completely surrounded by the first anode electrode, the pixel defining layer, the organic separator layer, and the common electron layer.

3. The display device of claim 2, wherein the first opening is inside the second opening in a plan view.

4. The display device of any one of claims 1 to 3, wherein the common electron layer extends to overlap the light emitting area and the non-light emitting area,
wherein the common electron layer is in contact with the first light emitting layer and the organic separator layer, and
wherein the common electron layer completely covers the first light emitting layer and the organic separator layer.

5. The display device of claim 4, wherein the common electron layer is in contact with the common electrode to overlap the non-light emitting area.

6. The display device of any one of claims 1 to 5, further comprising:
a second anode electrode spaced from the first anode electrode with the pixel defining layer positioned therebetween; and
a second light emitting layer on the second anode electrode,
wherein the first light emitting layer and the second light emitting layer are spaced from each other by the pixel defining layer and the organic separator layer.

7. The display device of claim 6, wherein the common electron layer covers the second light emitting layer, and
wherein the first light emitting layer, the organic separator layer, and the second light emitting layer are connected by the common electron layer.

8. The display device of claim 6 or claim 7, wherein the organic separator layer comprises:
a first surface in contact with the pixel defining layer;
a first side surface in contact with the first light emitting layer;
a second side surface in contact with the second light emitting layer; and
a second surface in contact with the common electron layer, optionally wherein the organic separator layer is completely surrounded by the pixel defining layer, the first light emitting layer, the second light emitting layer, and the common electron layer.

9. The display device of any one of claims 6 to 8, wherein a gap between the first light emitting layer and the second light emitting layer in a direction parallel to the substrate is completely filled by the organic separator layer.

10. The display device of any one of claims 1 to 9, wherein the organic separator layer comprises a single material or a mixture comprising any one of silicon-based, epoxy-based, and acrylic-based organic materials.

11. A display device comprising:
a substrate comprising a plurality of light emitting areas and a plurality of non-light emitting areas;
an anode electrode on the light emitting area of the substrate;
a pixel defining layer on the non-light emitting area of the substrate and defining a first opening;
an organic separator layer on the pixel defining layer and defining a second opening;
a light emitting layer on the anode electrode;
a common electron layer on the light emitting layer and the organic separator layer; and
a common electrode on the common electron layer,
wherein the second opening completely surrounds the first opening in a plan view,
wherein the organic separator layer does not overlap the light emitting area in a plan view, and
wherein the organic separator layer is in a mesh shape while surrounding the plurality of light emitting areas in a plan view.

12. The display device of claim 11, wherein the organic separator layer overlaps the pixel defining layer in a direction perpendicular to the substrate in a plan view.

13. The display device of claim 12, wherein the organic separator layer completely surrounds the anode electrode and the light emitting layer in a plan view, optionally wherein the common electron layer completely covers the light emitting layer and the organic separator layer in a plan view, further optionally wherein the common electrode completely covers the light emitting layer and the organic separator layer in a plan view.

14. A method of fabricating a display device, the method comprising:
forming a substrate having a light emitting area and a non-light emitting area, a first anode electrode and a second anode electrode spaced from each other on the light emitting area of the substrate, and a pixel defining layer overlapping the non-light emitting area of the substrate and between the first anode electrode and the second anode electrode;
forming a first light emitting layer by:
forming a first light emitting material layer completely covering the first anode electrode, the second anode electrode, and the pixel defining layer;
forming a sacrificial layer on the first light emitting material layer; and
removing a remaining portion of the first light emitting material layer and the sacrificial layer except for a portion overlapping the first anode electrode through an etching process;
forming a second light emitting layer by:
forming a second light emitting material layer completely covering the first light emitting layer, the second anode electrode, and the pixel defining layer;
forming a sacrificial layer on the second light emitting material layer; and
removing the second light emitting material layer and the sacrificial layer except for a portion overlapping the second anode electrode through an etching process;
forming an organic separator layer by:
forming an organic separator material layer on the first light emitting layer, the second light emitting layer, and the pixel defining layer;
etching a portion of the organic separator material layer; and
exposing the sacrificial layer overlapping each of the first and second light emitting layers;
removing the sacrificial layer using a wet etching process;
forming a common electron injection layer completely covering the first light emitting layer, the second light emitting layer, and the organic separator layer;
forming a common electrode on the common electron injection layer,
wherein the organic separator layer does not overlap the light emitting area, and
wherein the organic separator layer fills and planarizes a gap between the first light emitting layer and the second light emitting layer in a direction parallel to the substrate.

15. The method of claim 14, wherein the sacrificial layer comprises a metal material, and
wherein the sacrificial layer comprises aluminium or silver, optionally wherein the removing of the sacrificial layer comprises applying an acidic etching solution to the sacrificial layer, further optionally wherein the first light emitting layer and the second light emitting layer are formed by a photo lithography process.
